# FASCICULE DE BREVET EUROPEEN

(11) **EP 3 662 512 B1**
(45) Date de publication et mention de la délivrance du brevet: **25.08.2021**
(21) Numéro de dépôt: 18743551.6
(22) Date de dépôt: 30.07.2018
(51) Int. Cl.: H01L 27/146

(54) **PROCÉDÉ DE FABRICATION AMÉLIORÉ D'UN DÉTECTEUR OPTIQUE À BASE DE PHOTODIODES ET DISPOSITIF ASSOCIÉ**
VERFAHREN ZUR VERBESSERTEN HERSTELLUNG EINES PHOTODIODENBASIERTEN OPTISCHEN SENSORS UND ZUGEHÖRIGE VORRICHTUNG
METHOD FOR IMPROVED MANUFACTURING OF A PHOTODIODE-BASED OPTICAL SENSOR AND ASSOCIATED DEVICE

(30) Priorité: 03.08.2017 FR 1700824
(43) Date de publication de la demande: 10.06.2020
(73) Titulaire: Thales, 92400 Courbevoie (FR); Commissariat à l'Energie Atomique et aux Energies Alternatives, 75015 Paris (FR)
(72) Inventeur: LE GOFF, Florian, 91767 Palaiseau Cedex (FR); REVERCHON, Jean-Luc, 91767 Palaiseau Cedex (FR)
(74) Mandataire: Marks & Clerk France
(86) Numéro de dépôt international: PCT/EP2018/070570
(87) Numéro de publication internationale: WO 2019/025354

(56) Documents cités:
- WO-A1-2013/007753
- WO-A1-2017/103098
- FR-A1- 2 983 348

## Description

### DOMAINE DE L'INVENTION

L'invention concerne les détecteurs optiques de type hybride fonctionnant dans une plage de longueur d'onde donnée, typiquement l'infrarouge. Plus particulièrement l'invention se situe dans le domaine de l'imagerie à base de matrice de photodiodes.

### ETAT DE LA TECHNIQUE

Les imageurs opérant dans la gamme infrarouge sont généralement constitués par assemblage d'une matrice comprenant une pluralité de pixels élémentaires à base de photodiodes transformant un flux de photons incidents en porteurs photogénérés, et d'un circuit de lecture couramment dénommé ROIC pour « Read Out Integrated Circuit » en anglais pour traiter le signal électrique issu des pixels du détecteur. On dénomme cet assemblage hybridation.

Une technologie bien connue d'hybridation utilise des billes d'indium destinées à la connexion électrique de la matrice au circuit de lecture et permet la compensation des différences de coefficients de dilatation thermique entre circuit de lecture et matrice de photodiodes. Cette configuration n'est pas vitale dans le cas de composants non refroidis à base de matériaux semi-conducteurs III-V, par exemple du type InGaAs sur substrat InP. Elle engendre même un surcoût notable. Différentes solutions technologiques ont été avancées afin d'éliminer l'usage de billes d'indium : Polymères conducteurs, billes or-étain... Ces techniques restent difficiles à mettre en œuvre et permettent difficilement de diminuer le pas du pixel en dessous de 10 µm.

Une autre technologie utilise l'assemblage par collage du circuit ROIC avec l'imageur, ce qui pose le problème de la connexion électrique entre la matrice de photodiodes et les contacts associés du circuit ROIC.
Une structure résolvant ce problème comprend des trous d'interconnexion dénommés en anglais « via-hole » et des photodiodes de symétrie cylindrique autour de ces trous d'interconnexion. Cette photodiode est communément appelée « loop-hole ». Cette structure, consistant à réaliser un imageur infrarouge en couplant interconnexion 3D (circuit ROIC) et photodiode cylindrique, est dénommée « loop-hole », et est connue depuis les années 80. Une structure « loop hole » avec comme couche absorbante du HgCdTe (ou MCT) est décrite dans la publication « 50 years of HgCdTe at Texas Instruments and beyond » de Michael A. Kinch, SPIE vol 7298, 72982T-1, 2009.

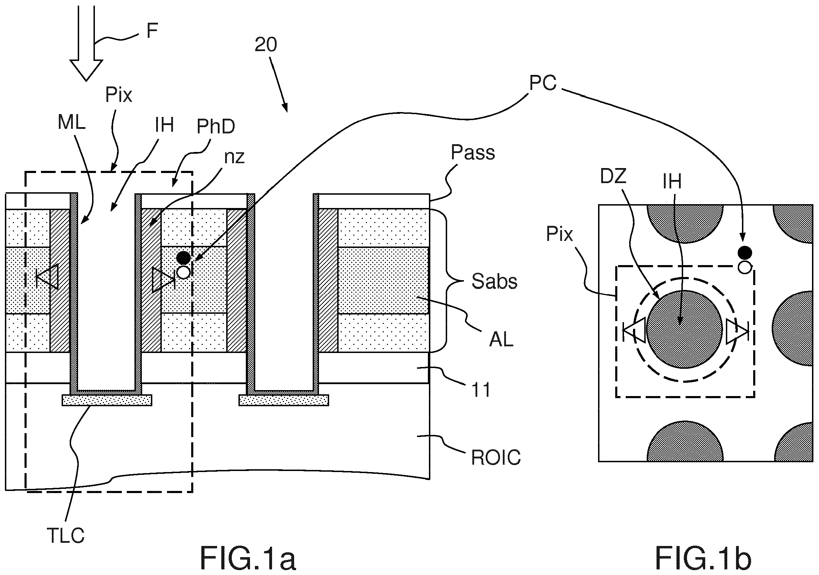

Un détecteur optique hybride 20 présentant une matrice de photodiode de type « loop hole » adaptée pour une structure absorbante réalisée avec des matériaux III-V est illustré figure 1, la figure 1a correspondant à une coupe transversale et la figure 1b à une vue de dessus.
La matrice de photodétecteurs comprend une structure absorbante Sabs comprenant au moins une couche absorbante AL en matériau III-V, apte à générer des porteurs PC à partir d'un flux de photons incidents F. La structure Sabs est recouverte d'une couche de passivation Pass. Cette structure est assemblée au circuit ROIC par une couche d'assemblage 11, typiquement un diélectrique.
Les contacts du circuit de lecture ROIC destinés à recevoir le signal électrique généré par chaque pixel Pix du détecteur sont des contacts TLC enterrés dénommés « Top Level Contacts » en anglais. Ils sont réalisés en fin de procédé de fabrication des circuits intégrés, et sont localisés proches de la surface du circuit.
Une diode cylindrique PhD est réalisée autour d'un trou d'interconnexion IH, qui traverse la structure absorbante, la couche d'assemblage 11 et le circuit ROIC jusqu'au contact TLC. Les parois du trou IH sont recouvertes d'une couche de métallisation ML, réalisant la liaison électrique entre la diode PhD et le contact TLC.

La diode PhD est réalisée par dopage localisé d'une zone DZ proche du trou IH (p dans l'exemple de la figure 1) d'un type opposé au dopage initial de la couche absorbante AL (n dans l'exemple de la figure 1). La photodiode de type p-n réalise la séparation et le transport des porteurs photo-générés vers la couche de métallisation ML.

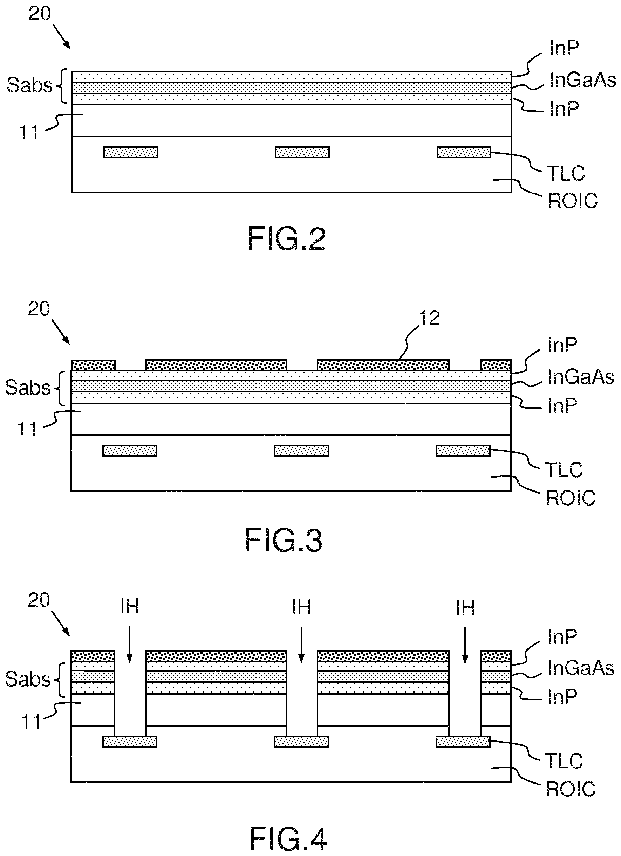

Le document WO2013079603 décrit une méthode de fabrication d'un détecteur 20 à base de diodes « loop hole » tel que décrit ci-dessus, avec une couche absorbante AL en matériau III-V. Un exemple est une couche absorbante en InGaAs dopé n disposée entre deux couches d'encapsulation en InP. Le détecteur 20 du document WO2013079603 présente une configuration d'illumination spécifique à travers le substrat, et un double imageur Visible/IR.
Le principe du procédé est illustré figures 2 à 6.

Dans une première étape illustrée figure 2 une structure semi-conductrice Sabs comprenant les trois couches précitées est assemblée, via une couche d'assemblage 11, à un circuit de lecture ROIC présentant des contacts enterrés TLC. L'assemblage est réalisé par collage, technique en plein développement et qui constitue un progrès important pour la réalisation d'étapes technologiques dites « above IC », c'est-à-dire d'étapes réalisables directement sur la plaque du circuit de lecture ROIC, typiquement de type CMOS, et de manière collective sur l'ensemble des puces. Cette compatibilité avec les moyens de fabrication CMOS est adaptée à une baisse significative des coûts de production et à la possibilité d'atteindre des motifs technologiques de taille plus fine.

Puis on dépose un diélectrique de masquage 12 sur la structure Sabs, et on effectue une gravure d'une partie de la couche diélectrique de masquage en regard des contacts TLC tel que représenté figure 3.
Les trous d'interconnexion IH sont réalisés par gravure verticale jusqu'aux contacts TLC, au travers de la structure absorbante et de la couche d'assemblage illustré figure 4. La gravure est réalisée par voie sèche ou par voie humide.

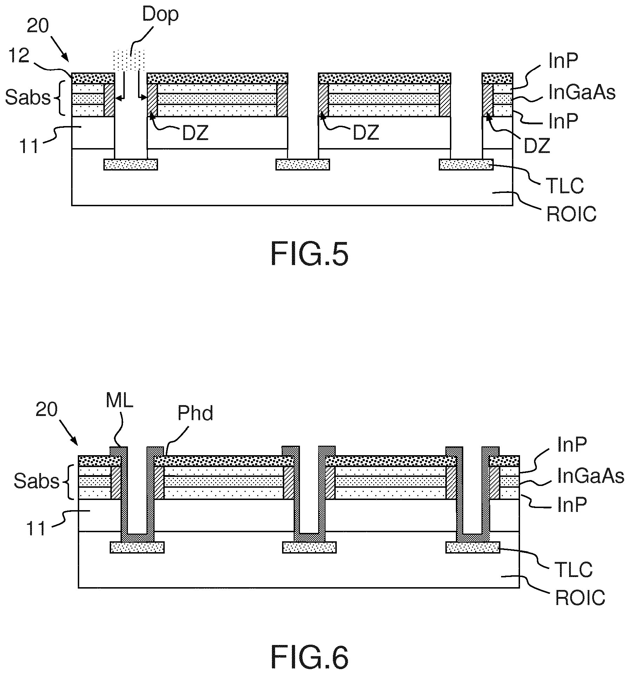

Lors d'une étape illustrée figure 5, on réalise une zone dopée DZ, par exemple de type p, par diffusion ou implantation ionique d'un dopant Dop via chaque trou IH, de manière à former une photodiode PhD comprenant une jonction p-n cylindrique. La diffusion s'opère à partir de la surface des parois du trou IH, et en parallèle au travers de toutes les couches composant la structure absorbante. De préférence la zone DZ est obtenue par diffusion d'atomes de Zinc.
Dans une étape finale illustrée figure 6 on procède au dépôt d'une couche métallique ML sur les parois des trous IH de manière à mettre en contact électrique la zone dopée DZ et le contact TLC.

Le procédé de réalisation de la diode « loop hole » est réalisé après l'assemblage avec le circuit ROIC, il doit donc être effectué à une température inférieure à la température maximale que peut supporter le circuit, typiquement de l'ordre de 400°C.

Ce procédé présente un certain nombre d'inconvénients, dû principalement à l'étape de diffusion du dopant. En effet lors de cette étape la surface du via est directement exposée et risque d'être dégradée lors du dopage par diffusion. Ce sont l'ensemble des couches constituant la structure absorbante qui se retrouvent exposées à l'atmosphère suite à la gravure des trous d'interconnexion.

En particulier les inventeurs ont montré dans le document « surface analysis of InP and InGaAs after low temperature diffusion of Zinc », IOP publishing, Semicond. Sci. Technol. 31, (2016), 095008, qu'une surface d'InP est dégradée lors d'un dopage par diffusion de Zinc, pour des températures inférieures à 425°C : il se forme un composé parasite de type ZnₓP₂ en consommant le phosphore, ainsi que des nano-billes d'indium, rendant la surface d'InP inhomogène (le problème disparait à plus haute température). Dans ce document un dopage Cadmium au lieu de Zinc est préconisé pour éviter cet effet. Mais le Cadmium est un composé toxique, et son utilisation dans un procédé industriel est problématique. En outre, la profondeur de diffusion est plus faible, ce qui diminue l'écrantage des états électroniques en surface du trou et entraine une augmentation des courants d'obscurité du détecteur en fonctionnement.

Un but de la présente invention est de pallier les inconvénients précités avec un procédé de fabrication d'un détecteur optique de type hybride présentant une étape de dopage par diffusion ne dégradant pas les performances de la structure de type « loop hole ».

### DESCRIPTION DE L'INVENTION

Selon un premier aspect, la présente invention a pour objet un procédé de fabrication d'un détecteur optique de type hybride comprenant les étapes consistant à :
- assembler par une couche d'assemblage d'une part une structure absorbante sensible dans une bande de longueur d'onde d'intérêt, ladite structure comprenant au moins une couche absorbante en matériau semi-conducteur III-V présentant un premier type de dopage choisi parmi n ou p, et d'autre part un circuit de lecture comprenant une pluralité de contacts enterrés, le circuit de lecture étant destiné à récupérer un signal électrique à partir des porteurs photogénérés par absorption d'une lumière par la couche semi-conductrice absorbante et,
- graver localement au travers de la structure absorbante, de la couche d'assemblage et du circuit de lecture jusqu'aux contacts, de manière à constituer des trous d'interconnexion électrique,
- déposer une couche de protection sur les parois des trous d'interconnexion,
- réaliser une zone dopée d'un deuxième type de dopage différent du premier type de dopage par diffusion d'un dopant dans la structure absorbante au travers de ladite couche de protection, ladite zone s'étendant de manière annulaire autour desdits trous d'interconnexion (IH) de manière à constituer une diode comprenant une jonction p-n permettant la séparation et le transport des porteurs photogénérés,
- déposer une couche de métallisation sur les parois des trous d'interconnexion permettant de relier électriquement la zone dopée avec le contact, de manière à réaliser une connexion électrique entre couche absorbante et circuit de lecture.

Selon une variante le procédé de fabrication selon l'invention comprend en outre une étape de retrait de ladite couche de protection après l'étape de réalisation de la zone dopée et préalablement à l'étape de dépôt de la couche de métallisation.
Selon un mode de réalisation la couche de protection est une couche comprenant un matériau semi-conducteur sensiblement en accord de maille avec le ou les matériaux semi-conducteurs de la structure absorbante, et dans lequel la couche de protection présente une concentration de défauts rendant incompatible ladite couche de protection avec un fonctionnement correct de ladite diode.
Avantageusement la méthode de dépôt de la couche de protection est une méthode d'épitaxie.
Selon un autre mode de réalisation la couche de protection est une couche diélectrique.
Selon un autre mode de réalisation la couche de protection est une couche semi-conductrice appartenant à une famille de matériaux différente de celle du ou des matériaux de la structure absorbante, ladite couche n'étant alors pas en accord de maille avec le ou les matériaux semi-conducteurs de la structure absorbante.

Selon un mode de réalisation la méthode de dépôt de la couche de protection est une méthode de dépôt couche monoatomique par couche monoatomique.

Selon une autre variante la couche de protection est une couche comprenant un matériau semi-conducteur en accord de maille avec le ou les matériaux semi-conducteurs de la structure absorbante et dans lequel la couche de protection présente une concentration de défauts suffisamment faible pour être compatible avec un fonctionnement correct de la diode p-n.

Selon une variante les trous d'interconnexion sont cylindriques et de section carrée. Avantageusement les trous d'interconnexion de section carrée sont orientés horizontalement de manière à sélectionner deux plans cristallographiques prédéterminés.

Selon une autre variante les trous d'interconnexion sont coniques et de section carrée.

Avantageusement la couche de protection présente une épaisseur comprise entre 1 à 50 nm.
Avantageusement le dépôt de la couche de protection est réalisé à une température inférieure à 450 °C.
Avantageusement le dopant est le Zinc.

Selon un mode de réalisation le matériau III-V de la couche absorbante est l'InGaAs présentant un premier type de dopage n, la couche absorbante étant disposée entre deux couches d'encapsulation en InP également dopées type n.

Selon un autre aspect l'invention concerne un détecteur optique de type hybride comprenant :
- une structure absorbante sensible dans une bande de longueur d'onde d'intérêt, ladite structure comprenant au moins une couche absorbante en matériau semi-conducteur III-V présentant un premier type de dopage choisi parmi n ou p, et un circuit de lecture comprenant une pluralité de contacts enterrés, le circuit de lecture étant destiné à récupérer un signal électrique à partir des porteurs photogénérés par absorption d'une lumière par la couche semi-conductrice absorbante, la structure absorbante et le circuit de lecture étant assemblés par une couche d'assemblage pour former le détecteur optique hybride,
- le détecteur comprenant en outre des trous d'interconnexion électrique traversant la structure absorbante, la couche d'assemblage et le circuit de lecture jusqu'aux contacts,
- la structure absorbante comprenant une zone dopée d'un deuxième type de dopage différent du premier type de dopage s'étendant de manière annulaire autour desdits trous d'interconnexion, de manière à constituer une diode comprenant une jonction p-n permettant la séparation et le transport des porteurs photogénérés,
- les parois du trou d'interconnexion en regard de la zone dopée étant recouvertes par une couche de protection constituée d'un matériau semi-conducteur en accord de maille avec le ou les matériaux semi-conducteurs de la structure absorbante, la couche de protection étant de qualité monocristalline,
- les parois de trous d'interconnexion étant en outre recouvertes d'une couche de métallisation, afin de relier électriquement la zone dopée avec le contact, de manière à réaliser une connexion électrique entre couche absorbante et circuit de lecture.

D'autres caractéristiques, buts et avantages de la présente invention apparaîtront à la lecture de la description détaillée qui va suivre et en regard des dessins annexés donnés à titre d'exemples non limitatifs et sur lesquels :
La figure 1 illustre un détecteur optique présentant une matrice de photodiodes de type « loop hole » à base des matériaux III-V.
La figure 2 illustre une première étape d'assemblage d'un procédé de fabrication du détecteur 20.
La figure 3 illustre une étape de dépôt et de masquage d'un diélectrique de masquage.
La figure 4 illustre une étape de réalisation de trous d'interconnexion.
La figure 5 illustre une étape de réalisation d'une zone dopée autour d'un trou d'interconnexion.
La figure 6 illustre une étape finale de métallisation des parois des trous d'interconnexion.
La figure 7 illustre les étapes du procédé selon l'invention.
La figure 8 illustre une première variante du procédé selon l'invention.
La figure 9 est un diagramme présentant les différents composés semi-conducteurs comme des points, avec en abscisse le gap et en ordonnée la valeur en Angströms de la maille élémentaire.
La figure 10 illustre une deuxième variante du procédé selon l'invention dans laquelle la couche de protection est une couche semi-conductrice en accord de maille avec le ou les matériaux semi-conducteurs et de qualité cristallographique.
La figure 11 illustre une variante dans laquelle les trous d'interconnexion de section carrée sont orientés horizontalement d'un angle déterminé.
La figure 12 illustre un mode de réalisation dans lequel les trous d'interconnexion sont en forme de cône.
La figure 13 illustre un détecteur selon l'invention.

### DESCRIPTION DETAILLEE DE L'INVENTION

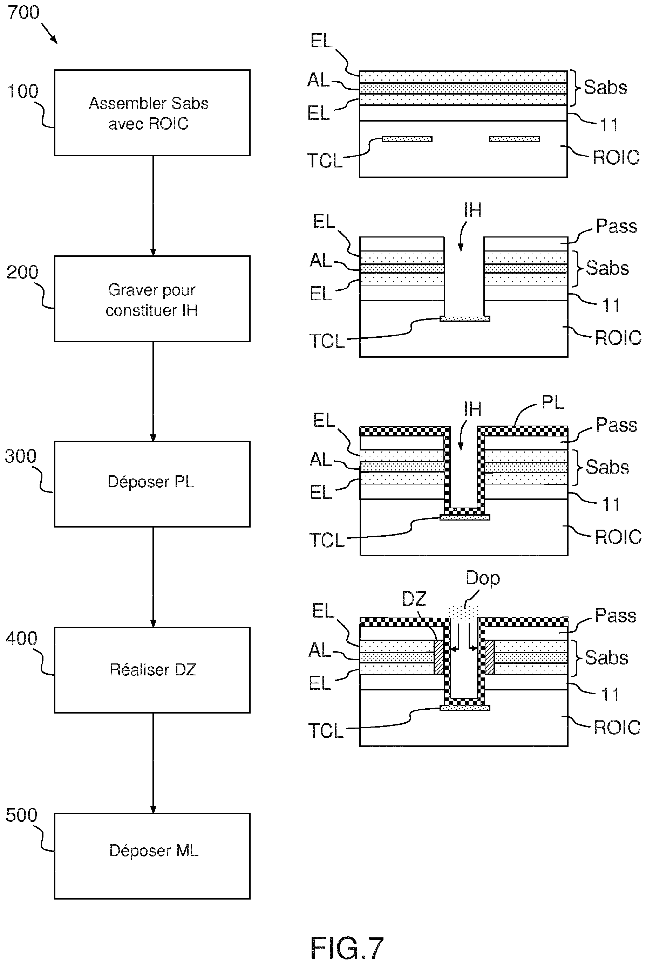

Le procédé de fabrication 700 d'un détecteur optique de type hybride selon l'invention est illustré figure 7.
Le procédé comprend une première étape 100 consistant à assembler par une couche d'assemblage 11 d'une part une structure absorbante Sabs sensible dans une bande de longueur d'onde d'intérêt et d'autre part un circuit de lecture ROIC comprenant une pluralité de contacts TLC enterrés. La structure Sabs comprend au moins une couche absorbante AL en matériau semi-conducteur III-V présentant un premier type de dopage choisi parmi n ou p. L'épaisseur totale de la structure est de l'ordre de quelques micromètres.
Le circuit de lecture ROIC est destiné à récupérer un signal électrique à partir des porteurs photogénérés par absorption d'une lumière par la couche semi-conductrice absorbante AL.
Il s'agit d'une étape similaire à l'étape décrite sur la figure 2.
Ici l'assemblage est préférentiellement réalisé par collage moléculaire. Cette méthode consiste à préparer spécifiquement la surface des deux structures avec des dépôts de silice et planarisations puis à les mettre en contact mécaniquement, puis à réaliser un recuit thermique (de l'ordre de 200°C).

Selon un mode de réalisation également illustré figure 7 la structure absorbante Sabs comprend deux couches d'encapsulation EL disposées de part et d'autre de la couche absorbante AL et présentant une bande interdite d'une valeur supérieure à la valeur de la bande interdite de la couche absorbante. Ces couches sont également dénommées « couche fenêtre » et servent principalement à écranter les états de surface pouvant générer un signal parasite.
Les couches fenêtre doivent être en accord de maille avec la couche absorbante. Tout l'empilement Sabs est réalisé lors de la même croissance épitaxiale. Par exemple le matériau III-V de la couche absorbante est l'InGaAs présentant un premier dopage de type n (qui peut être intrinsèque), la couche absorbante étant disposée entre deux couches d'encapsulation en InP (qui sont typiquement dopées faiblement n, c'est-à-dire entre 10¹⁵ et 10¹⁷ cm⁻³). On obtient alors une détection dans la plage dite SWIR (Short Wavelength InfraRed, de 0.9 à 1.7 µm).

Dans une deuxième étape 200 on grave localement au travers de la structure absorbante Sabs, de la couche d'assemblage 11 et du circuit de lecture jusqu'aux contacts TLC, de manière à constituer des trous d'interconnexion électrique IH. Cette étape est similaire à l'étape décrite figures 3 et 4. Le diamètre des trous d'interconnexion est préférentiellement compris entre 1 et 4 µm.

Le procédé selon l'invention comprend ensuite une troisième étape 300 consistant à déposer une couche de protection PL sur les parois des trous d'interconnexion IH.
Comme décrit plus loin cette couche de protection PL peut être de diverse nature.

Ensuite dans une quatrième étape 400 on réalise une zone dopée DZ d'un deuxième type de dopage différent du premier type de dopage par diffusion dans la structure absorbante d'un dopant Dop au travers de la couche de protection PL via les trous IH. La zone dopée DZ s'étend dans la structure absorbante de manière annulaire autour des trous IH de manière à constituer une diode « loop hole » comprenant une jonction p-n permettant la séparation et le transport des porteurs photogénérés lorsque le détecteur est illuminé par un faisceau lumineux à détecter.
L'ensemble des étapes, et particulièrement les étapes de dépôt de PL et de diffusion, doivent être réalisées à une température compatible avec ce que peut supporter le circuit ROIC, soit typiquement une température inférieure à 400°C.

La couche PL ne doit pas être dégradée pendant la diffusion, et permet de protéger les couches constituant la structure absorbante Sabs pendant l'étape de diffusion. Préférentiellement la couche de protection est fine, présentant une épaisseur comprise entre 1 à 50 nm, plus préférentiellement 1 à 20 nm, car elle doit permettre au dopant Dop de diffuser dans les matériaux de la structure Sabs à doper.
En outre cette couche a une influence sur la profondeur et le niveau de dopage de la zone DZ, essentiellement du fait de la modification que sa présence induit sur l'état de surface des parois au travers desquelles s'opère la diffusion (concentration en lacune ,...). Pour l'exemple d'une structure absorbante InP/InGaAs/InP, la couche de protection va permettre la protection des couches d'InP, dégradées par le Zinc comme exposé plus haut.

Selon un mode de réalisation le dopant Dop est le Zinc, le dopage avec des atomes de Zinc induisant un dopage de type p.

Enfin le procédé selon l'invention comprend une étape 500 de dépôt d'une couche de métallisation ML sur les parois des trous d'interconnexion, permettant de relier électriquement la zone dopée DZ avec le contact TLC, de manière à réaliser une connexion électrique entre couche absorbante AL et circuit de lecture ROIC.

Le procédé selon l'invention permet ainsi la réalisation d'un détecteur optique hybride à base de photodiodes de type « loop hole » en garantissant que l'étape de diffusion ne dégrade pas les parois des trous, conduisant ultérieurement à bon un fonctionnement des diodes p-n (ou n-p) « loop hole ». En outre la présence de la couche PL agit comme un « moteur » de diffusion qui améliore la profondeur de pénétration des atomes du dopant Dop et augmente sa concentration donc le niveau de dopage. Cela écrante plus efficacement les défauts électroniques induits par le via-hole, améliorant les performances du détecteur en termes de signal parasite.

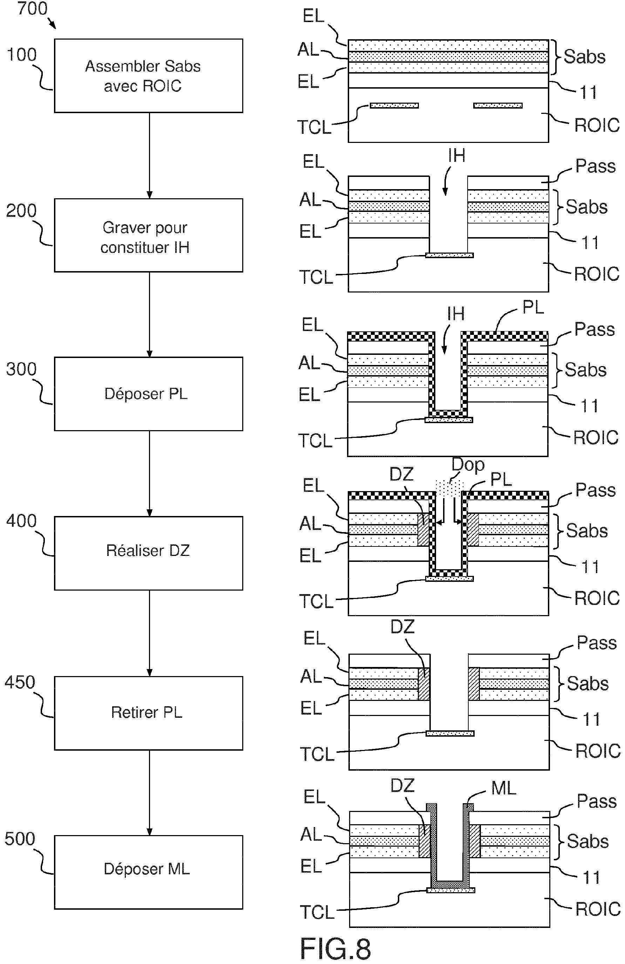

Selon une première variante du procédé de fabrication selon l'invention, la couche de protection ne présente pas une qualité suffisante pour être conservée. Selon cette variante, le procédé selon l'invention comprend en outre une étape de retrait 450 de la couche de protection PL une fois l'étape de diffusion du dopant 400 réalisée et préalablement à l'étape de dépôt 500 de la couche de métallisation, tel qu'illustré figure 8.
Le retrait s'opère typiquement par gravure chimique humide ou sèche (plasma).

Selon un premier mode de réalisation nécessitant le retrait de la couche PL, la couche de protection est une couche PLsca comprenant un matériau semi-conducteur sensiblement en accord de maille avec le ou les matériaux semi-conducteurs constituant la structure absorbante. Ce mode de réalisation correspond au cas où la couche de protection semi-conductrice PL présente une concentration de défauts trop importante, ne permettant pas un transport des porteurs compatible avec un bon fonctionnement de la diode « loop hole ».

Par sensiblement en accord de maille on entend un accord suffisant pour permettre l'utilisation, pour le dépôt de la couche PLsca, d'une méthode d'épitaxie. Il peut s'agit d'une épitaxie par jet moléculaire, MBE pour « Molecular beam Epitaxy » en anglais; GSMBE pour Gas Source Molecular Beam Epitaxy, ou en phase vapeur : MOVPE pour Metal Oxyde Vapor Phase Epitaxy ; HVPE pour Hydride Vapor Phase Epitaxy ...

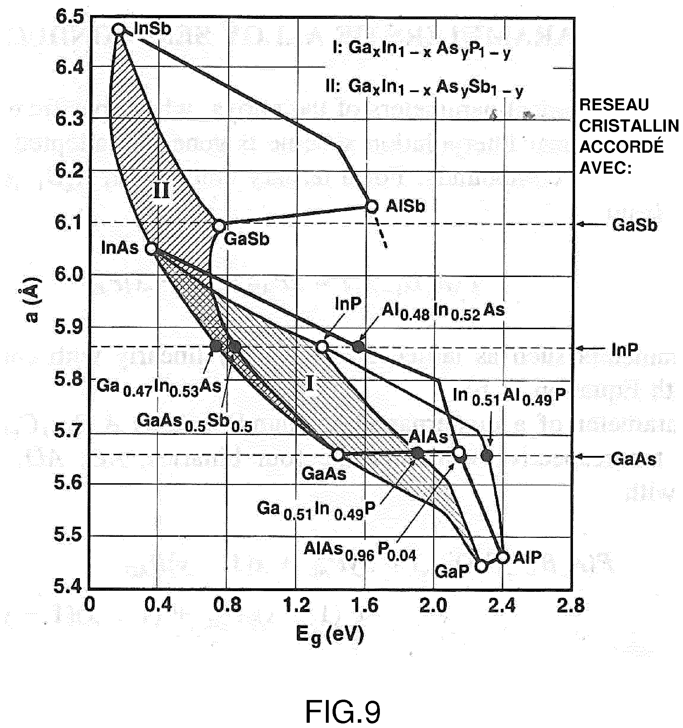

Typiquement la couche PL présente une épaisseur de 1 à 100 nm, préférentiellement 1 à 50 nm. Cette épaisseur dépend de la facilité de dépôt et du facteur de forme du via (diamètre versus profondeur).
La couche est préférentiellement localisée sur les parois du via correspondant à la tranche de la structure absorbante Sabs, mais peut éventuellement se former sur la tranche de la couche de passivation et au fond sur le contact. Il existe des familles de composés semi-conducteurs présentant un bon accord de maille, illustré figure 9. La figure 9 présente les différents composés comme des points sur un diagramme avec en abscisse le gap en eV et en ordonnée la valeur en Angströms de la maille élémentaire. Pour l'exemple d'une structure absorbante InP/InGaAs/InP, le dépôt d'une couche de protection en Ga_{0.47}In_{0.53}As permet un tel accord de maille.

Selon un deuxième mode de réalisation nécessitant le retrait de la couche PL, également illustré figure 8, la couche de protection est une couche diélectrique PLd. Typiquement le matériau diélectrique est choisi parmi : HfO₂ ; SiO₂ Al₂O₃.
L'avantage d'utiliser un diélectrique est que l'on n'est pas contraint par la condition d'accord de maille, et que l'on peut utiliser des méthodes de dépôt à plus basse température, telles que la pulvérisation, l'évaporation,ou le dépôt en phase plasma. La nature de cette couche étant très différente de celle de la structure absorbante, il est plus aisé de l'éliminer.
La couche recouvre totalement les parois et le fond du via.
Préférentiellement pour obtenir un dépôt très fin de quelques nm présentant une épaisseur maîtrisée, un dépôt monocouche atomique par monocouche atomique est réalisé, dénommé ALD pour « Atomic Layer Déposition » en anglais.

Selon un troisième mode de réalisation, la couche de protection est une couche semi conductrice PLscna d'une famille différente de celle des composés de structure absorbante, et n'est donc pas en accord de maille avec ceux-ci. Cette couche peut être également déposée avec une méthode couvrante de type ALD.
Typiquement le semi conducteur est du ZnO, ZnSe, c'est une réalisation équivalente à la réalisation avec diélectrique.

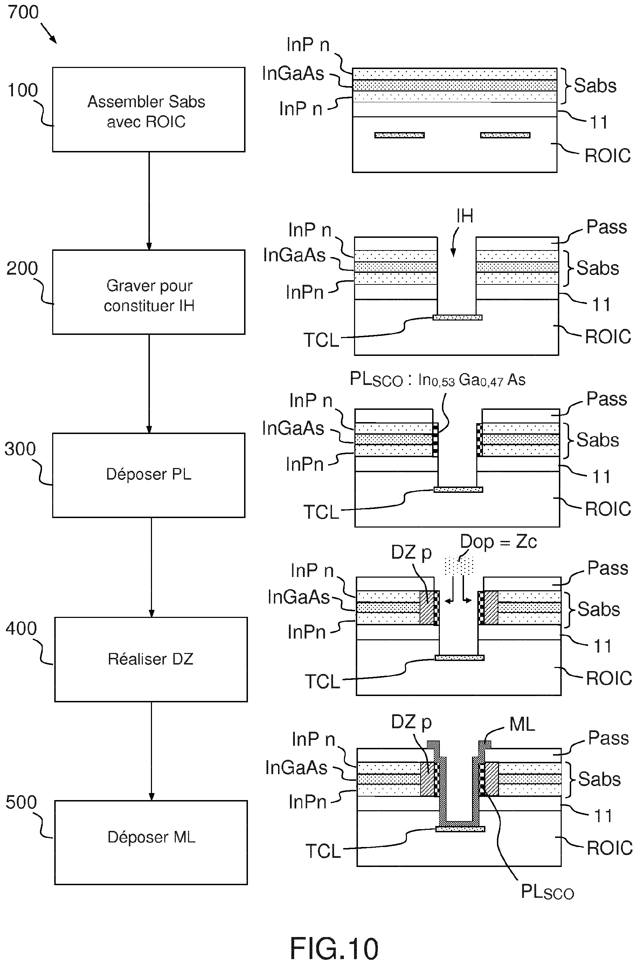

Selon une deuxième variante illustrée figure 10 la couche de protection est une couche semi-conductrice PLsc0 en accord de maille avec le ou les matériaux semi-conducteur de la structure absorbante, et présentant une concentration de défauts suffisamment faible pour permettre le transport des porteurs. La couche PLsc0 est ainsi compatible avec un fonctionnement correct de la diode p-n « loop hole ». Elle n'est donc plus éliminée.
La figure 10 illustre l'exemple d'une structure absorbante InP/InGaAs/InP.

Cette couche est déposée par une méthode d'épitaxie dans laquelle le contrôle de l'ensemble des paramètres du dépôt est renforcé. On parle de « reprise d'épitaxie », et la couche PLsc0 est donc monocristalline.

Du fait qu'il s'agit d'une reprise d'épitaxie, cette couche est localisée uniquement sur les parois du via correspondant à la tranche des couches constituant la couche absorbante, comme illustré figure 10 sur le schéma correspondant aux étapes 300, 400 et 500.
Pour la structure InP/InGaAs/InP, cette couche est en Ga_{0.47}In_{0.53}As.
Cette couche est plus délicate à réaliser, mais présente l'avantage d'être compatible du fonctionnement de la diode « loop hole », il n'y a pas besoin de la retirer après l'étape de diffusion. En effet elle a le même type de dopage que Sabs pour un dopant donné et est électriquement conductrice ce qui permet la continuité électrique avec la structure.

Le dépôt de la couche de métallisation ML s'opère donc par-dessus la couche épitaxiale PLscO, comme illustré figure 10, sur le schéma en regard de l'étape finale 500.

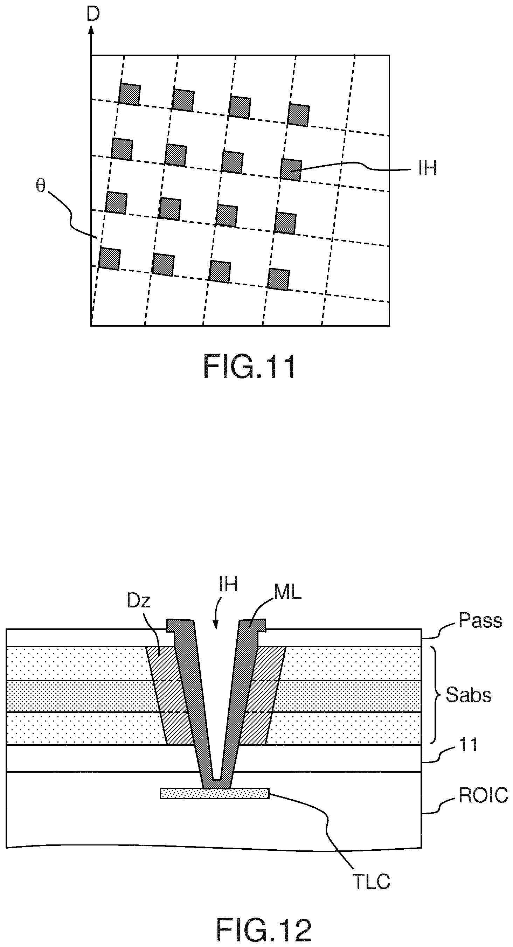

Selon un mode de réalisation les trous d'interconnexion ou via sont de forme cylindrique et de section carrée. Les parois planes verticales du trou d'interconnexion IH en résultant permettent d'obtenir un nombre de directions de croissance limité à 2. Ainsi il devient plus simple de déterminer les conditions thermodynamiques de la croissance épitaxiale. En variante, les trous d'interconnexion de section carrée sont orientés horizontalement d'un angle θ déterminé de manière à sélectionner dans le via IH les plans cristallographiques les plus adaptés au procédé de croissance utilisé, tel qu'illustré figure 11, correspondant à une vue de dessus du détecteur optique. L'angle θ est par exemple repéré par rapport à la direction D perpendiculaire au grand méplat. Dans le cas de la structure absorbante en InP et InGaAs, il est connu qu'un angle de 0° donne le matériau repris de meilleure qualité.

Selon un autre mode de réalisation, les trous d'interconnexion sont en forme de cône, tel qu'illustré figure 12 pour un détecteur fabriqué avec une méthode de fabrication selon la première variante (retrait de la couche PL). Préférentiellement les via sont de section carrée.

Au niveau des matériaux constituant la structure absorbante (dite active), pour les couches d'encapsulation à grand gap et collecteur d'électrons on peut remplacer l'InP par InAlSb, GaSb ou AlₓGa₍₁₋ₓ₎As_{y}Sb_{(1-y)}. Pour la couche absorbante à plus petit gap, on peut remplacer l'InGaAs par l'InSb ou l'InAsSb pour obtenir des imageurs en bandes MWIR.
D'autres associations de semi conducteurs sont possibles, en fonction de la plage de longueur d'onde d'intérêt souhaitée. Les exemples ci-dessous sont donnés de manière indicative et non exhaustive.

| Gamme spectrale d'intérêt | Couche fenêtre à grand gap | Couche absorbante à plus petit gap |
|---|---|---|
| SWIR | InP | InGaAs |
| SWIR | Si | SiGe ou Ge |
| MWIR | GaSb ou AlₓGa₍₁₋ₓ₎As_{y}Sb_{(1-y)} | InAsSb ou SRL InAsSb/InAs |
| MWIR | InAlSb | InSb |
| LWIR | GaSb ou AlₓGa₍₁₋ₓ₎As_{y}Sb_{(1-y)} | SRL GaSb / InAs |
| UV | AlGaN AlInN | GaN ou AlGaN |

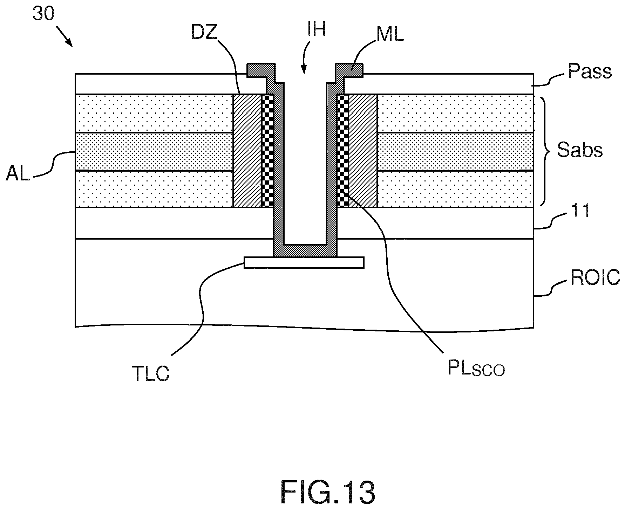

Selon un autre aspect l'invention concerne un détecteur optique 30 de type hybride illustré figure 13 et comprenant :
- une structure absorbante Sabs sensible dans une bande de longueur d'onde d'intérêt, ladite structure comprenant au moins une couche absorbante AL en matériau semi conducteur III-V présentant un premier type de dopage choisi parmi n ou p, et un circuit de lecture ROIC comprenant une pluralité de contacts TLC enterrés. Le circuit de lecture est destiné à récupérer un signal électrique à partir des porteurs photogénérés par absorption d'une lumière par la couche semi conductrice absorbante AL. La structure absorbante et le circuit de lecture sont assemblés par une couche d'assemblage 11 pour former le détecteur optique 30 hybride.
   Le détecteur 30 comprend en outre des trous d'interconnexion IH électrique ou via traversant la structure absorbante Sabs, la couche d'assemblage 11 et le circuit de lecture ROIC jusqu'aux contacts TLC.
   La structure absorbante comprend une zone dopée DZ d'un deuxième type de dopage différent du premier type de dopage s'étendant de manière annulaire autour desdits trous d'interconnexion IH, de manière à constituer une diode PhD comprenant une jonction p-n permettant la séparation et le transport des porteurs photogénérés.
   Les parois de trous d'interconnexions en regard de la zone dopée (DZ) étant recouvertes une couche de protection (PLscO) constituée d'un matériau semi conducteur en accord de maille avec le ou les matériaux semi-conducteurs de la structure absorbante, la couche de protection étant de qualité cristallographique,
   Les parois des trous d'interconnexions étant en outre recouvertes d'une couche de métallisation ML, afin de relier électriquement la zone dopée (DZ) avec le contact TLC, de manière à réaliser une connexion électrique entre couche absorbante AL et circuit de lecture ROIC.

Le détecteur 30 est le détecteur réalisé selon la variante du procédé de fabrication selon l'invention illustrée figure 10. La couche de protection PLsco est déposée par une méthode d'épitaxie sur les parois de la zone dopée.

## Revendications

1. Procédé de fabrication (700) d'un détecteur optique de type hybride comprenant les étapes consistant à :
- assembler (100) par une couche d'assemblage (11) d'une part une structure absorbante (Sabs) sensible dans une bande de longueur d'onde d'intérêt, ladite structure comprenant au moins une couche absorbante en matériau semi-conducteur III-V (AL) présentant un premier type de dopage choisi parmi n ou p, et d'autre part un circuit de lecture (ROIC) comprenant une pluralité de contacts (TLC) enterrés, le circuit de lecture étant destiné à récupérer un signal électrique à partir des porteurs photogénérés par absorption d'une lumière par la couche semi-conductrice absorbante (AL) et,
- graver (200) localement au travers de la structure absorbante, de la couche d'assemblage et du circuit de lecture jusqu'aux contacts, de manière à constituer des trous d'interconnexion (IH) électrique,
- déposer (300) une couche de protection (PL, PLsca, PLd, PLscna, PLscO) sur les parois des trous d'interconnexion,
- réaliser (400) une zone dopée (DZ) d'un deuxième type de dopage différent du premier type de dopage par diffusion d'un dopant (Dop) dans la structure absorbante au travers de ladite couche de protection, ladite zone s'étendant de manière annulaire autour desdits trous d'interconnexion (IH) de manière à constituer une diode (PhD) comprenant une jonction p-n permettant la séparation et le transport des porteurs photogénérés,
- déposer (500) une couche de métallisation (ML) sur les parois des trous d'interconnexion (IH) permettant de relier électriquement la zone dopée (DZ) avec le contact (TLC), de manière à réaliser une connexion électrique entre couche absorbante (AL) et circuit de lecture (ROIC).

2. Procédé de fabrication selon la revendication 1 comprenant en outre une étape de retrait (450) de ladite couche de protection (PLsca, PLd, PLscna) après l'étape (400) de réalisation de la zone dopée et préalablement à l'étape de dépôt (500) de la couche de métallisation.

3. Procédé de fabrication selon la revendication 2 dans lequel la couche de protection (PLsca) est une couche comprenant un matériau semi-conducteur sensiblement en accord de maille avec le ou les matériaux semi-conducteurs de la structure absorbante, et dans lequel la couche de protection présente une concentration de défauts rendant incompatible ladite couche de protection avec un fonctionnement correct de ladite diode.

4. Procédé selon la revendication 3 dans lequel la méthode de dépôt de la couche de protection est une méthode d'épitaxie.

5. Procédé selon la revendication 2 dans lequel la couche de protection (PLd) est une couche diélectrique.

6. Procédé selon la revendication 2 dans lequel la couche de protection (PLscna) est une couche semi-conductrice appartenant à une famille de matériaux différente de celle du ou des matériaux de la structure absorbante, ladite couche n'étant alors pas en accord de maille avec le ou les matériaux semi-conducteurs de la structure absorbante.

7. Procédé selon les revendications 5 ou 6 dans lequel la méthode de dépôt de la couche de protection est une méthode de dépôt couche monoatomique par couche monoatomique (ALD).

8. Procédé selon la revendication 1 dans lequel la couche de protection est une couche (PLscO) comprenant un matériau semi-conducteur en accord de maille avec le ou les matériaux semi-conducteurs de la structure absorbante et dans lequel la couche de protection présente une concentration de défauts suffisamment faible pour être compatible avec un fonctionnement correct de la diode p-n.

9. Procédé selon l'une des revendications précédentes dans lequel les trous d'interconnexion sont cylindriques et de section carrée

10. Procédé selon la revendication 9 dans lequel les trous d'interconnexion de section carrée sont orientés horizontalement de manière à sélectionner deux plans cristallographiques prédéterminés.

11. Procédé selon l'une des revendications 1 à 8 dans lequel les trous d'interconnexion sont coniques et de section carrée.

12. Procédé de fabrication selon l'une des revendications précédentes dans lequel la couche de protection présente une épaisseur comprise entre 1 à 50 nm.

13. Procédé de fabrication selon l'une des revendications précédentes dans lequel le dépôt de la couche de protection est réalisé à une température inférieure à 450 °C.

14. Procédé de fabrication selon l'une des revendications précédentes dans lequel le dopant est le Zinc.

15. Procédé selon l'une des revendications précédentes dans lequel le matériau III-V de la couche absorbante est l'InGaAs présentant un premier type de dopage n, la couche absorbante étant disposée entre deux couches d'encapsulation en InP également dopées type n.

16. Détecteur optique (30) de type hybride comprenant :
- une structure absorbante (Sabs) sensible dans une bande de longueur d'onde d'intérêt, ladite structure comprenant au moins une couche absorbante en matériau semi-conducteur III-V (AL) présentant un premier type de dopage choisi parmi n ou p, et un circuit de lecture (ROIC) comprenant une pluralité de contacts (TLC) enterrés, le circuit de lecture étant destiné à récupérer un signal électrique à partir des porteurs photogénérés par absorption d'une lumière par la couche semi-conductrice absorbante (AL), la structure absorbante et le circuit de lecture étant assemblés par une couche d'assemblage (11) pour former le détecteur optique (30) hybride,
- le détecteur comprenant en outre des trous d'interconnexion (IH) électrique traversant la structure absorbante, la couche d'assemblage (11) et le circuit de lecture (ROIC) jusqu'aux contacts (TLC),
- la structure absorbante comprenant une zone dopée (DZ) d'un deuxième type de dopage différent du premier type de dopage s'étendant de manière annulaire autour desdits trous d'interconnexion (IH), de manière à constituer une diode (PhD) comprenant une jonction p-n permettant la séparation et le transport des porteurs photogénérés,
- les parois du trou d'interconnexion en regard de la zone dopée (DZ) étant recouvertes par une couche de protection (PLsc0) constituée d'un matériau semi-conducteur en accord de maille avec le ou les matériaux semi-conducteurs de la structure absorbante, la couche de protection étant de qualité monocristalline,
- les parois de trous d'interconnexion étant en outre recouvertes d'une couche de métallisation (ML), afin de relier électriquement la zone dopée (DZ) avec le contact (TLC), de manière à réaliser une connexion électrique entre couche absorbante (AL) et circuit de lecture (ROIC).

## Patentansprüche

1. Verfahren zur Herstellung (700) eines optischen Detektors des Hybridtyps, das die folgenden Schritte umfasst:
- Montieren (100), mittels einer Montageschicht (11), einerseits einer absorbierenden Struktur (Sabs), die in einem Wellenlängenband von Interesse empfindlich ist, wobei die Struktur mindestens eine absorbierende Schicht aus III-V-Halbleitermaterial (AL) mit einem aus n oder p ausgewählten ersten Dotierungstyp umfasst, und andererseits eine Leseschaltung (ROIC), die eine Vielzahl von vergrabenen Kontakten (TLC) umfasst, wobei die Leseschaltung zum Gewinnen eines elektrischen Signals der durch Absorption von Licht durch die absorbierende Halbleiterschicht (AL) photogenerierten Ladungsträger bestimmt ist, und
- lokales Ätzen (200) durch die absorbierende Struktur, die Montageschicht und die Leseschaltung bis zu den Kontakten, um elektrische Durchgangslöcher (IH) zu bilden,
- Abscheiden (300) einer Schutzschicht (PL, PLsca, PLd, PLscna, PLsc0) auf den Wänden der Durchgangslöcher,
- Realisieren (400) einer dotierten Zone (DZ) eines zweiten Dotierungstyps, der sich vom ersten Dotierungstyp unterscheidet, durch Diffusion eines Dotierungsmittels (Dop) in die absorbierende Struktur durch die Schutzschicht, wobei sich die Zone ringförmig um die Durchgangslöcher (IH) erstreckt, um eine Diode (PhD) zu bilden, die einen p-n-Übergang umfasst, der die Trennung und den Transport der photogenerierten Ladungsträger ermöglicht,
- Abscheiden (500) einer Metallisierungsschicht (ML) auf den Wänden der Durchgangslöcher (IH), so dass die dotierte Zone (DZ) mit dem Kontakt (TLC) verbunden werden kann, um eine elektrische Verbindung zwischen der absorbierenden Schicht (AL) und der Leseschaltung (ROIC) zu realisieren.

2. Herstellungsverfahren nach Anspruch 1, das ferner einen Schritt des Entfernens (450) der Schutzschicht (PLsca, PLd, PLscna) nach dem Schritt (400) des Realisierens der dotierten Zone und vor dem Schritt des Abscheidens (500) der Metallisierungsschicht umfasst.

3. Herstellungsverfahren nach Anspruch 2, wobei die Schutzschicht (PLsca) eine Schicht ist, die ein Halbleitermaterial umfasst, das im Wesentlichen in Gitterübereinstimmung mit dem/den Halbleitermaterial(ien) der absorbierenden Struktur ist, und wobei die Schutzschicht eine Konzentration von Defekten aufweist, die die Schutzschicht mit einem korrekten Betrieb der Diode inkompatibel macht.

4. Verfahren nach Anspruch 3, wobei das Verfahren zum Abscheiden der Schutzschicht ein epitaktisches Verfahren ist.

5. Verfahren nach Anspruch 2, wobei die Schutzschicht (PLd) eine dielektrische Schicht ist.

6. Verfahren nach Anspruch 2, wobei die Schutzschicht (PLscna) eine Halbleiterschicht ist, die zu einer anderen Materialfamilie gehört als das/die Material(ien) der absorbierenden Struktur, wobei die Schicht dann nicht in Gitterübereinstimmung mit dem/den Halbleitermaterial(ien) der absorbierenden Struktur ist.

7. Verfahren nach Anspruch 5 oder 6, wobei das Verfahren zum Abscheiden der Schutzschicht ein ALD-(Rolle-zu-Rolle-Atomlagenabscheidung)-Verfahren ist.

8. Verfahren nach Anspruch 1, wobei die Schutzschicht eine Schicht (PLscO) ist, die ein Halbleitermaterial in Gitterübereinstimmung mit dem/den Halbleitermaterial(ien) der absorbierenden Struktur umfasst, und wobei die Schutzschicht eine ausreichend niedrige Defektkonzentration aufweist, um mit einem korrekten Betrieb der p-n-Diode kompatibel zu sein.

9. Verfahren nach einem der vorherigen Ansprüche, wobei die Durchgangslöcher zylindrisch und im Querschnitt quadratisch sind.

10. Verfahren nach Anspruch 9, wobei die Durchgangslöcher mit quadratischem Querschnitt horizontal orientiert sind, um zwei vorbestimmte kristallographische Ebenen auszuwählen.

11. Verfahren nach einem der Ansprüche 1 bis 8, wobei die Durchgangslöcher konisch und im Querschnitt quadratisch sind.

12. Herstellungsverfahren nach einem der vorherigen Ansprüche, wobei die Schutzschicht eine Dicke zwischen 1 und 50 nm aufweist.

13. Herstellungsverfahren nach einem der vorherigen Ansprüche, wobei das Abscheiden der Schutzschicht bei einer Temperatur unter 450°C erfolgt.

14. Herstellungsverfahren nach einem der vorherigen Ansprüche, wobei das Dotierungsmittel Zink ist.

15. Verfahren nach einem der vorherigen Ansprüche, wobei das III-V-Material der absorbierenden Schicht InGaAs mit einem ersten n-Dotierungstyp ist, wobei die absorbierende Schicht zwischen zwei gleichmäßig n-dotierten InP-Kapselungsschichten angeordnet ist.

16. Optischer Detektor (30) des Hybridtyps, der Folgendes umfasst:
- eine absorbierende Struktur (Sabs), die in einem Wellenlängenband von Interesse empfindlich ist, wobei die Struktur mindestens eine absorbierende Schicht aus III-V-Halbleitermaterial (AL) mit einem aus n oder p ausgewählten ersten Dotierungstyp und eine Leseschaltung (ROIC), umfassend eine Vielzahl von vergrabenen Kontakten (TLC) umfasst, wobei die Leseschaltung zum Gewinnen eines elektrischen Signals von den durch Absorption von Licht durch die absorbierende Halbleiterschicht (AL) photogenerierten Ladungsträgern bestimmt ist, wobei die absorbierende Struktur und die Leseschaltung durch eine Montageschicht (11) montiert werden, um den optischen Hybriddetektor (30) zu bilden,
- wobei der Detektor ferner elektrische Durchgangslöcher (IH) umfasst, die durch die absorbierende Struktur, die Montageschicht (11) und die Leseschaltung (ROIC) bis zu den Kontakten (TLC) führen,
- wobei die absorbierende Struktur eine dotierte Zone (DZ) eines zweiten Dotierungstyps aufweist, der sich vom ersten Dotierungstyp unterscheidet und sich ringförmig um die Durchgangslöcher (IH) erstreckt, um eine Diode (PhD) zu bilden, die einen p-n-Übergang aufweist, der die Trennung und den Transport der photogenerierten Ladungsträger ermöglicht,
- wobei die Wände des Durchgangslochs gegenüber der dotierten Zone (DZ) mit einer Schutzschicht (PLsc0) aus einem Halbleitermaterial in Gitterübereinstimmung mit dem/den Halbleitermaterial(ien) der absorbierenden Struktur bedeckt sind, wobei die Schutzschicht Einkristallqualität aufweist,
- wobei die Wände der Durchgangslöcher ferner mit einer Metallisierungsschicht (ML) bedeckt sind, um die dotierte Zone (DZ) mit dem Kontakt (TLC) elektrisch zu verbinden, um so eine elektrische Verbindung zwischen der absorbierenden Schicht (AL) und der Leseschaltung (ROIC) zu realisieren.

## Claims

1. A process for fabricating (700) a hybrid optical detector comprising the steps of:
- assembling (100), via an assembly layer (11), on the one hand an absorbing structure (Sabs) that is sensitive in a wavelength band of interest, said structure comprising at least one absorbing layer made of III-V semiconductor (AL) having a first doping type chosen from n or p, and on the other hand a read-out circuit (ROIC) comprising a plurality of buried contacts (TLC), the read-out circuit being intended to receive an electrical signal generated from the carriers photogenerated by absorption of light by the absorbing semiconductor layer (AL) and
- locally etching (200), through the absorbing structure, the assembly layer and the read-out circuit up to the contacts, so as to form electrical via-holes (IH),
- depositing (300) a protective layer (PL, PLsca, PLd, PLscna, PLsc0) on the walls of the via-holes,
- producing (400) a doped region (DZ) of a second doping type different from the first doping type by diffusing a dopant (Dop) into the absorbing structure through said protective layer, said region extending annularly around said via-holes (IH) so as to form a diode (PhD) comprising a p-n junction allowing the photogenerated carriers to be separated and transported,
- depositing (500) a metallization layer (ML) on the walls of the via-holes (IH) allowing the doped region (DZ) to be electrically connected to the contact (TLC), so as to make an electrical connection between absorbing layer (AL) and read-out circuit (ROIC).

2. The fabricating process according to claim 1, furthermore comprising a step of removing (450) said protective layer (PLsca, PLd, PLscna) after the step (400) of producing the doped region and prior to the step of depositing (500) the metallization layer.

3. The fabricating process according to claim 2, wherein the protective layer (PLsca) is a layer comprising a semiconductor that is substantially lattice matched with the one or more semiconductors of the absorbing structure, and wherein the protective layer has a defect concentration making said protective layer incompatible with a correct operation of said diode.

4. The process according to claim 3, wherein the method used to deposit the protective layer is an epitaxial method.

5. The process according to claim 2, wherein the protective layer (PLd) is a dielectric layer.

6. The process according to claim 2, wherein the protective layer (PLscna) is a semiconductor layer belonging to a family of materials different from that of the one or more materials of the absorbing structure, said layer then not being lattice matched with the one or more semiconductors of the absorbing structure.

7. The process according to claim 5 or 6, wherein the method used to deposit the protective layer is an atomic-layer-deposition method (ALD).

8. The process according to claim 1, wherein the protective layer is a layer (PLsc0) comprising a semiconductor that is lattice matched with the one or more semiconductors of the absorbing structure and wherein the protective layer has a sufficiently low defect concentration to be compatible with a correct operation of the p-n diode.

9. The process according to one of the preceding claims, wherein the via-holes are cylindrical and of square cross section.

10. The process according to claim 9, wherein the via-holes of square cross section are oriented horizontally so as to select two preset crystal planes.

11. The process according to one of claims 1 to 8, wherein the via-holes are conical and of square cross section.

12. The fabricating process according to one of the preceding claims, wherein the protective layer has a thickness comprised between 1 and 50 nm.

13. The fabricating process according to one of the preceding claims, wherein the protective layer is deposited at a temperature below 450°C.

14. The fabricating process according to one of the preceding claims, wherein the dopant is zinc.

15. The process according to one of the preceding claims, wherein the III-V material of the absorbing layer is InGaAs having an n first doping type, the absorbing layer being placed between two encapsulating layers made of InP also doped n-type.

16. A hybrid optical detector (30) comprising:
- an absorbing structure (Sabs) that is sensitive in a wavelength band of interest, said structure comprising at least one absorbing layer made of III-V semiconductor (AL) having a first doping type chosen from n or p, and a read-out circuit (ROIC) comprising a plurality of buried contacts (TLC), the read-out circuit being intended to receive an electrical signal generated from the carriers photogenerated by absorption of light by the absorbing semiconductor layer (AL), the absorbing structure and the read-out circuit being assembled via an assembly layer (11) to form the hybrid optical detector (30),
- the detector furthermore comprising electrical via-holes (IH) that pass through the absorbing structure, the assembly layer (11) and the read-out circuit (ROIC) up to the contacts (TLC),
- the absorbing structure comprising a doped region (DZ) of a second doping type different from the first doping type extending annularly around said via-holes (IH), so as to form a diode (PhD) comprising a p-n junction allowing the photogenerated carriers to be separated and transported,
- the walls of the via-hole facing the doped region (DZ) being covered with a protective layer (PLsc0) made of a semiconductor that is lattice matched with the one or more semiconductors of the absorbing structure, the protective layer being of single-crystal quality,
- the via-hole walls furthermore being covered with a metallization layer (ML), in order to electrically connect the doped region (DZ) to the contact (TLC), so as to make an electrical connection between absorbing layer (AL) and read-out circuit (ROIC).
